# EUROPÄISCHE PATENTANMELDUNG

(11) **EP 2 190 011 A2**
(43) Veröffentlichungstag der Anmeldung: **26.05.2010**
(21) Anmeldenummer: 09012245.8
(22) Anmeldetag: 26.09.2009
(51) Int. Cl.: H01L 23/04, H01L 23/10, H01L 23/48

(54) **Feuchtigkeitsdichtes Leistungshalbleitermodul mit Zentriereinrichtung**

(30) Priorität: 20.11.2008 DE 102008058189
(71) Anmelder: SEMIKRON Elektronik GmbH & Co. KG, 90431 Nürnberg (DE)
(72) Erfinder: Ebersberger, Frank, 90518 Altdorf (DE); Seidler, Andreas, 90431 Nürnberg (DE)

(57) **Zusammenfassung**

Die Erfindung beschreibt ein Leistungshalbleitermodul mit mindestens einem ersten und einem zweiten Lastanschlusskörper, mit mindestens einem zwischen diesen Lastanschlusskörpern angeordnetem Sandwich mit einem ersten Metallzylinder, einem Leistungshalbleiterbauelement und einem zweiten Metallzylinder und mit einer Zentriereinrichtung zur konzentrischen Anordnung der Einzelteile des Sandwiches, wobei die Zentriereinrichtung die übrigen Einzelteile des Sandwiches derart umschließt, dass die Mantelflächen der Metallzylinder in einer Nut der Zentriereinrichtung angeordnet sind und der Randbereich des Leistungshalbleiterbauelements in einer Vertiefung dieser Nut angeordnet ist, und wobei die Zentriereinrichtung je eine Dichteinrichtung zum ersten und zweiten Lastanschlusskörper aufweist.

## Beschreibung

Die Erfindung beschreibt ein Leistungshalbleitermodul mit mindestens einem ersten und einem zweiten Lastanschlusskörper, die mit externen Zuleitungen verbunden sind. Zwischen mindestens zwei dieser Lastanschlusskörper ist, vorzugsweise druckkontaktiert, ein Sandwich mit einem ersten Metallzylinder, einem Leistungshalbleiterbauelement und einem zweiten Metallzylinder angeordnet. Hierdurch sind die Einzelteile des Sandwiches kraftschlüssig und elektrisch leitend miteinander verbunden. Zur Vereinfachung des Herstellungsprozesses weist ein derartiges Leistungshalbleitermodul häufig eine Zentriereinrichtung zur konzentrischen Anordnung der Einzelteile des Sandwiches auf.

Derartige Leistungshalbleitermodule sind in einer Vielzahl von speziellen Ausgestaltungen bekannt. Eine einfach und daher grundlegende Ausgestaltung ist beispielhaft in der DE 100 22 341 A1 offenbart. Hierbei bilden zwei Metallschienen die beiden Lastanschlusskörper, zwischen denen ein Halbleiterbauelement angeordnet ist. Weiterhin weist das Leistungshalbleitermodul je Halbleiterbauelement eine Druckeinrichtung auf, die eine kraftschlüssig elektrisch leitende Verbindung zwischen den Lastanschlusskörpern und dem jeweiligen Leistungshalbleiterbauelement herstellt.

Es ist weiterhin bekannt das jeweilige Leistungshalbleiterbauelement nicht direkt mit dem Lastanschlusskörper zu verbinden. Durch die unterschiedlichen Ausdehnungskoeffizienten des meist aus Silizium bestehenden Leistungshalbleiterbauelements und den meist aus Kupfer bestehenden Lastanschlusskörpern kommt es bei thermischer Beanspruchung zu Beschädigungen des Leistungshalbleiterbauelements. Um dies zu verhindern wird zwischen Lastanschlusskörper und Leistungshalbleiterbauelement gemäß dem Stand der Technik mindestens ein weiterer Metallkörper meist in Zylinderform mit einem Ausdehnungskoeffizient, der zwischen denjenigen seiner beiden Nachbarn liegt, angeordnet.

Aus der DE 100 65 495 A1 ist eine Zentriereinrichtung für ein Leistungshalbleiterbauelement bekannt durch die ein Leistungshalbleiterbauelement und zwei Metallzylinder konzentrisch zueinander angeordnet werden und gleichzeitig eine Montageeinheit bilden. Hierzu weist die zweiteilige rahmenartige Zentriereinrichtung eine Mehrzahl von Haltenasen auf, die ein Trennen des Sandwiches aus einem ersten Metallzylinder, einem Leistungshalbleiterbauelement und einem zweiten Metallzylinder verhindern. Zur drucklosen Anordnung der Zentriereinrichtung weisen die Lastanschlusskörper Ausnehmungen zur Aufnahme der Haltenasen auf. Das Leistungshalbleiterbauelement selbst ist in einer Nut der Zentriereinrichtung angeordnet. Alle Elemente werden durch die Zentriereinrichtung lose zueinander angeordnet und weisen eine gewisse Beweglichkeit zueinander sowohl lateral als senkrecht hierzu auf.

Zur Kontaktierung eines Steueranschlusses eines Leistungshalbleiterbauelements in einem bekannten Leistungshalbleitermodul ist beispielhaft aus der DE 10 2004 050 588 A1 eine Kontakteinrichtung bekannt. Diese Kontakteinrichtung kann beispielhaft direkt in einer Ausnehmung eines Lastanschlusskörpers eines o.g. Leistungshalbleitermoduls angeordnet sein. Hierzu weist die Kontakteinrichtung einen metallischen Teil und eine diesen umschließende und gegenüber dem Lastanschlusskörper elektrisch isolierende Hülse auf. Diese Hülse ist derart ausgebildet, dass sie mittels Rastnasen in dem Lastanschlusskörper arretiert werden kann.

Das beschriebene Leistungshalbleitermodul mit den jeweils im Weiteren genannten Komponenten weist den Nachteil auf bei seiner Verwendung nicht gegen Feuchtigkeit geschützt zu sein, wodurch im Besonderen das Leistungshalbleiterbauelement beschädigt und damit unbrauchbar werden kann. Daher müssen in einem dieses Leistungshalbleitermodul umschließenden Gehäuse Mittel vorgesehen werden das gesamte Leistungshalbleitermodul gegen Feuchtigkeit zu schützen.

Der Erfindung liegt die Aufgabe zugrunde ein Leistungshalbleitermodul mit einem verbesserten inneren Aufbau vorzustellen, wodurch auch ein Schutz des mindestens einen Leistungshalbleiterbauelements erreicht wird.

Diese Aufgabe wird erfindungsgemäß gelöst, durch einen Gegenstand mit den Merkmalen des Anspruchs 1. Bevorzugte Ausführungsformen sind in den abhängigen Ansprüchen beschrieben.

Den Ausgangspunkt der Erfindung bilden Leistungshalbleitermodule der oben genannten Art mit mindestens einem ersten und einem zweiten Lastanschlusskörper. Zwischen einem ersten und einem zweiten Lastanschlusskörper ist mindestens ein Sandwich angeordnet, das eine Folge aus einem ersten Metallzylinder, einem Leistungshalbleiterbauelement und einem zweiten Metallzylinder aufweist. Diese Einzelteile des Sandwiches sind mittels einer Zentriereinrichtung konzentrisch zueinander angeordnet. Hierbei umschließt die Zentriereinrichtung die übrigen Einzelteile des Sandwiches derart, dass die Mantelflächen und der angrenzende Rand der Metallzylinder in einer Nut der Zentriereinrichtung angeordnet sind. Der Randbereich des einen Leistungshalbleiterbauelements, das einen größeren Durchmesser als die Metallzylinder aufweist, ist in einer Vertiefung dieser Nut angeordnet. Weiterhin weist die Zentriereinrichtung je eine, vorzugsweise als Dichtlippe ausgebildete, Dichteinrichtung zum ersten und zweiten Lastanschlusskörper auf, die dort bevorzugt in einer zugeordneten Ausnehmung angeordnet ist und durch eine Druckeinrichtung des Leistungshalbleitermoduls mit Druck beaufschlagt wird, wodurch die Dichtwirkung erreicht wird.

Hierbei ist es bevorzugt, wenn die Zentriereinrichtung aus einem dauerelastischen Material ausgebildet ist, wodurch eine kraftschlüssige Verbindung der Zentriereinrichtung zum Sandwich ausgebildet wird und auch die Einzelteile des Sandwiches zueinander kraftschlüssig verbunden werden.

Bei Leistungshalbleitermodulen mit steuerbaren Leistungshalbleiterbauelementen ist es besonders bevorzugt, wenn sowohl der Lastanschlusskörper wie auch der zugeordnet Metallzylinder auf derjenigen Seite des Leistungshalbleiterbauelements auf der der Steueranschluss vorgesehen ist jeweils eine mit diesem fluchtende Ausnehmung aufweisen.

Hierbei weist die Ausnehmung des Lastanschlusskörpers sowohl ein Widerlager für eine Schnapp- Rast- Verbindung mit einer Kontakteinrichtung als auch eine erste Dichtfläche zur Kontakteinrichtung auf. Diese weist ebenfalls eine vorzugsweise parallel zur ersten Dichtfläche angeordnete zweite Dichtfläche auf. Zwischen den beiden Dichtflächen ist ein Dichtring angeordnet, der mittels der Schnapp- Rast- Verbindung mit Druck beaufschlagt wird wodurch die Dichtwirkung erreicht wird.

Besonders bevorzugte Weiterbildungen dieser Leistungshalbleitermodule sind in der jeweiligen Beschreibung der Ausführungsbeispiele genannt. Die erfinderische Lösung wird zudem an Hand der Ausführungsbeispiele der Fig. 1 bis 5 weiter erläutert.

Fig. 1 zeigt ein erfindungsgemäßes Leistungshalbleitermodul in dreidimensionaler Ansicht sowie im Querschnitt.

Fig. 2 zeigt einen weiteren Ausschnitt des Sandwiches des erfindungsgemäßen Leistungshalbleitermoduls gemäß Fig. 1.

Fig. 3 zeigt in zweidimensionaler Ansicht einen Ausschnitt der Anordnung eines Sandwiches mit einer zweiten, vereinfachten Ausgestaltung der Zentriereinrichtung.

Fig. 4 zeigt in zweidimensionaler Ansicht einen Ausschnitt eines Sandwiches mit einer dritten Ausgestaltung der Zentriereinrichtung.

Fig. 5 zeigt einen Ausschnitt eines Lastanschlusskörpers mit angeordneter Kontakteinrichtung eines erfindungsgemäßen Leistungshalbleitermoduls.

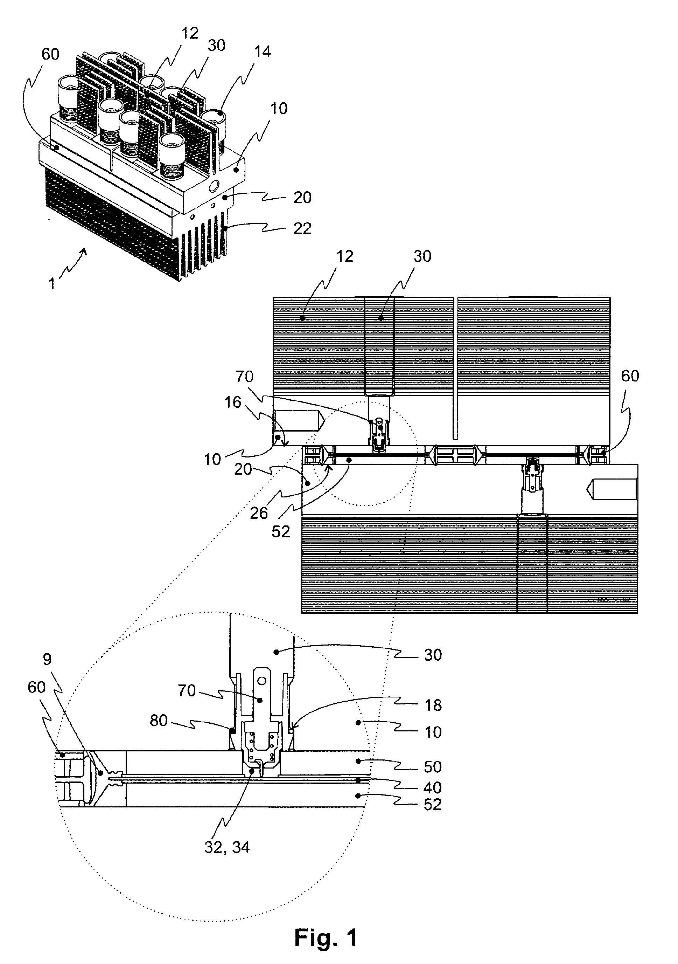

Fig. 1 zeigt ein erfindungsgemäßes Leistungshalbleitermodul (1) in dreidimensionaler Ansicht sowie im Querschnitt. Das Leistungshalbleitermodul (1) weist einen ersten (10) und einen zweiten Lastanschlusskörper (20) auf, zwischen denen zwei Leistungshalbleiterbauelement (40), hier zwei Thyristoren angeordnet und antiparallel verschaltet sind. Die elektrische Kontaktierung (70) der beiden Thyristoren erfolgt mittels Kraftschluss durch eine Druckkontaktierung zwischen den beiden Lastanschlusskörpern (10; 20). Hierzu weist das Leistungshalbleitermodul (1) pro Thyristor vier Schraubverbindungen (14) jeweils mit einer Mehrzahl von Tellerfedern auf. Weiterhin sind die beiden Lastanschlusskörper (10; 20) hier jeweils einstückig mit zugeordneten Kühleinrichtungen (12; 22) verbunden.

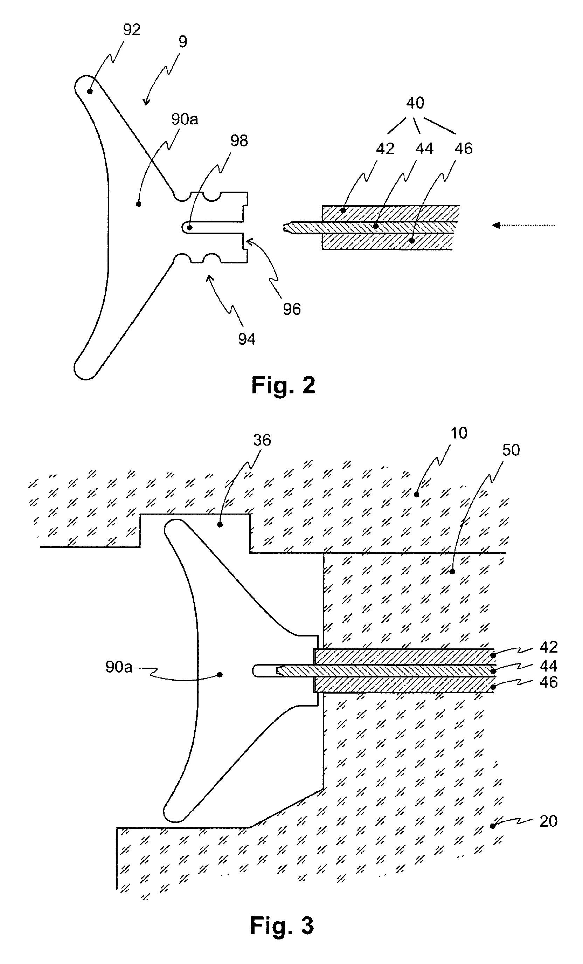

Zwischen den beiden Lastanschlusskörpern (10; 20) dieses Leistungshalbleitermoduls (1) ist ein rahmenartiger Kunststoffformkörper (60) mit zwei Aussparungen angeordnet. Wiederum ist in jeder dieser Aussparungen eine Abfolge aus einem ersten metallischen Anschlusselement (50) einem Sandwich (40), seinerseits bestehend aus einem ersten Metallzylinder (Fig. 2: 42), dem Thyristor (Fig. 2: 44), einem zweiten Metallzylinder (Fig. 2: 46) und mit einer Zentriereinrichtung (9) zur konzentrischen Anordnung der Einzelteile des Sandwiches (40) sowie einem zweiten Anschlusselement (52) angeordnet. Hierbei weist das erste Anschlusselement (50), wie auch der erste Metallzylinder (Fig. 2: 42) je eine Ausnehmung (32; 34) fluchtend mit der Steueranschlussfläche des Thyristors (44) auf.

Die Zentriereinrichtung (9) des Sandwiches (40) umschließt die übrigen Einzelteile des Sandwiches (40) derart, dass die Mantelflächen der Metallzylinder (Fig. 2: 42; 44) in einer Nut (Fig. 2: 96) der Zentriereinrichtung (9) angeordnet sind und der Randbereich des Leistungshalbleiterbauelements (Fig. 2: 44) in einer Vertiefung (Fig. 2: 98) dieser Nut (Fig. 2: 96) angeordnet ist. Weiterhin weist die Zentriereinrichtung (9) je eine Dichteinrichtung (Fig. 2: 92) zum ersten (10) und zweiten Lastanschlusskörper (20) auf, wobei hier die Dichteinrichtungen (Fig. 2: 92) plan am zugeordneten Lastanschlusskörper (10; 20) anliegen. Durch die vorgesehene Dichteinrichtung (Fig. 2: 92) der Zentriereinrichtung (9) ist der zugeordnete Thyristor (44) für Feuchtigkeit, die parallel zu den Planflächen (16; 26) der Lastanschlusskörper (10; 20) eindringen könnte geschützt.

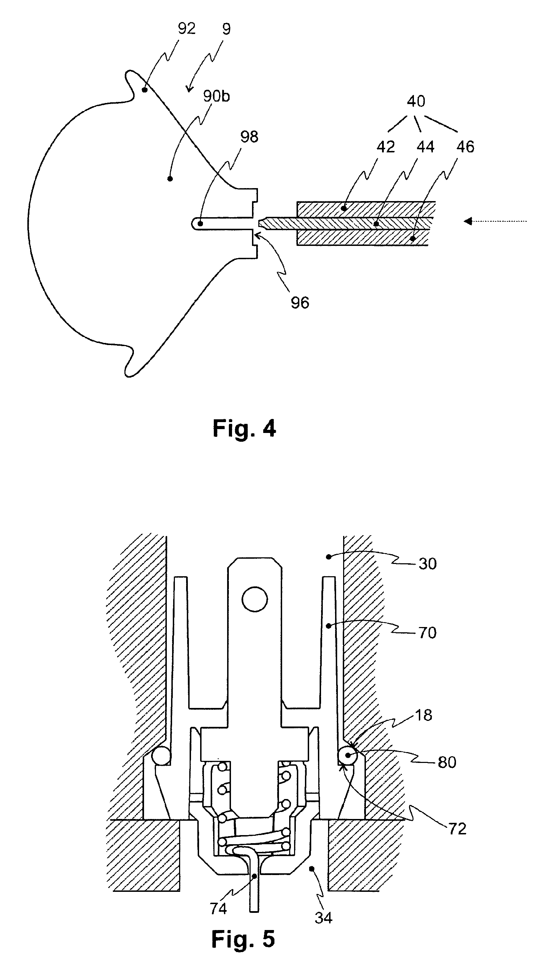

Zur Ansteuerung des Thyristors (44) weist weiterhin auch der Lastanschlusskörper (10; 20) eine mit den Ausnehmungen (32; 34) fluchtende Ausnehmung (30) des ersten Anschlusselements (50) und des ersten Metallzylinders (Fig. 2: 42) auf. In dieser Ausnehmung (30) ist eine Kontakteinrichtung (70) angeordnet. Diese Kontakteinrichtung (70) liegt mit einer Anschlagkante (16) auf der Oberfläche des ersten Anschlusselements (50) auf. Weiterhin der zugeordneten Lastanschlusskörper (10; 20) in der Ausnehmung (30) zur Aufnahme der Kontakteinrichtung (70) eine erste Dichtfläche (18) auf. Dieser ersten Dichtfläche (18) ist eine zweite Dichtfläche (Fig. 5: 72) der Kontakteinrichtung (70) zugeordnet. Zwischen den beiden Dichtflächen (18; 72) ist ein Dichtring (Fig. 5: 80) angeordnet. Durch den vorgesehenen Dichtring (Fig. 5: 80) der Kontakteinrichtung (70) ist der zugeordnete Thyristor (44) gegen Feuchtigkeit, die die zugeordnete Ausnehmung (30) des Lastanschlusskörpers (10; 22) eindringen könnte geschützt.

Es kann weiterhin bevorzugt sein, wenn die Kontakteinrichtung (70) mittels einer Schnapp- Rast- Verbindung in dem Lastanschlusskörper (10; 20) angeordnet ist und somit der Dichtring (Fig. 5: 80) mit Druck beaufschlagt ist.

Fig. 2 zeigt einen weiteren Ausschnitt des Sandwiches (40) des erfindungsgemäßen Leistungshalbleitermoduls (1) gemäß Fig. 1. Zur Übersicht ist hierbei die Zentriereinrichtung (9) lateral beabstandet dargestellt. In der realen Ausbildung umschließt selbstverständlich die Zentriereinrichtung (9) die übrigen Einzelteile des Sandwiches (40), die beiden Metallzylinder (42; 46) und das Leistungshalbleiterbauelement (44). Hierbei weist die Zentriereinrichtung (9) eine Nut (96) mit einer weiteren vorzugsweise mittig in dieser Nut (96) angeordneten Vertiefung (98) auf. Die Mantelflächen der Metallzylinder (42; 46) sind somit in der Nut (96) der Zentriereinrichtung (9) angeordnet, wobei die Deckflächen der Metallzylinder (42; 46) noch durch den Rand der Nut (96) geringfügig überdeckt sind. Der Randbereich des Leistungshalbleiterbauelements (44), das einen größeren Durchmesser als die Metallzylinder (42; 46) aufweist, ist in der Vertiefung (98) der Nut (92) angeordnet und reicht vorzugsweise nicht bis zum Boden der Vertiefung (98). Weiterhin ist es bevorzugt, wenn der Durchmesser der Metallzylinder (42; 46) und des Leistungshalbleiterbauelements (44) ein Verhältnis zur jeweiligen eigenen Höhe von mindestens 10:1 aufweist.

Die Zentriereinrichtung (9) weist weiterhin je eine Dichteinrichtung (92) zum ersten (10) und zweiten Lastanschlusskörper (20) auf. Hierzu ist die gesamte Zentriereinrichtung (9) aus einem dauerelastischen Material ausgebildet, wobei durch diese dauerelastische Ausbildung sich auch automatisch eine kraftschlüssige Verbindung der Zentriereinrichtung (9) zum Sandwich (40) ausgebildet wird.

In dieser Ausgestaltung weist die Zentriereinrichtung (9) einen meniskusförmigen Grundkörper (90a) auf, wobei an dessen konvexer Seite mittig die Aufnahme (94) für die Metallzylinder (42; 46) und das Leistungshalbleiterbauelement (44) angeordnet ist und hierdurch die Dichtfunktion von der Zentriereinrichtung (9) funktional getrennt ist.

Fig. 3 zeigt in zweidimensionaler Ansicht einen Ausschnitt der Anordnung eines Sandwiches (40) mit einer zweiten, vereinfachten Ausgestaltung der Zentriereinrichtung (9). Hierbei ist die Grundform im Wesentlichen meniskusförmig (90a), allerdings ohne die spezielle Trennung der Funktionalitäten wie in Fig. 2. Auch hier bilden die Enden des Meniskus die jeweiligen Dichteinrichtungen (92) aus.

Dargestellt sind zwei Varianten der Anordnung dieser Enden in einem Lastanschlusskörper (10; 20). Im oberen Bildteil weist der Lastanschlusskörper eine eigene Ausnehmung (36) zur Positionierung der zugeordneten Dichteinrichtung (92) auf. Dies hat den Vorteil, dass die als Dichtlippe ausgebildete Dichteinrichtung (92) einen lateralen Anschlag aufweist und somit die Gefahr einer Fehlpositionierung, die mit einer Fehlfunktion einher gehen könnte verringert ist.

Im unteren Bildteil ist der Dichteinrichtung (92) keine eigene Ausnehmung zugeordnet, ebenso wenig sind die oben beschrieben Lastanschlusskörper (10; 20) und das zugeordnete Anschlusselement (50; 52) zweistückig ausgebildet.

Fig. 4 zeigt in zweidimensionaler Ansicht einen Ausschnitt eines Sandwiches (40) mit einer dritten Ausgestaltung der Zentriereinrichtung (9), ähnlich Fig. 2. Hier weist der Grundkörper der Dichteinrichtung (92) im Querschnitt allerdings keine Meniskusform auf sondern ist im Wesentlichen kreisförmig (90b) ausgestaltet. Die gesamte Funktionalität bleibt hierbei allerdings erhalten.

Fig. 5 zeigt einen Ausschnitt eines Lastanschlusskörpers (10; 20) mit angeordneter Kontakteinrichtung (70) eines erfindungsgemäßen Leistungshalbleitermoduls (1). Dargestellt ist hier der Lastanschlusskörper (10) mit Ausnehmung (32; 34) zur Anordnung der Kontakteinrichtung (70). Diese Ausnehmung (32; 34) weist eine erste Dichtfläche (18) auf, der ein zweite Dichtfläche (72) der Kontakteinrichtung (70) zugeordnet ist. Zwischen diesen beiden Dichtflächen (18; 72) ist ein Dichtring (80) angeordnet.

Weiterhin weist die Kontakteinrichtung (70) einen Steckkontakt zum externen Verbindung mit einem Steueranschluss, sowie eine Kontaktfeder (74) zur Verbindung mit der Steueranschlussfläche des Leistungshalbleiterbauelements (44) auf.

## Patentansprüche

1. Leistungshalbleitermodul (1) mit mindestens einem ersten (10) und einem zweiten Lastanschlusskörper (20), mit mindestens einem zwischen diesen Lastanschlusskörpern (10; 20) angeordnetem Sandwich (40) mit einem ersten Metallzylinder (42), einem Leistungshalbleiterbauelement (44) und einem zweiten Metallzylinder (46) und mit einer Zentriereinrichtung (9) zur konzentrischen Anordnung der Einzelteile des Sandwiches (40), wobei die Zentriereinrichtung (9) die übrigen Einzelteile des Sandwiches (40) derart umschließt, dass die Mantelflächen der Metallzylinder (42; 46) in einer Nut (96) der Zentriereinrichtung (9) angeordnet sind und der Randbereich des Leistungshalbleiterbauelements (46) in einer Vertiefung (98) dieser Nut (96) angeordnet ist, und wobei die Zentriereinrichtung (9) je eine Dichteinrichtung (92) zum ersten (10) und zweiten Lastanschlusskörper (20) aufweist.

2. Leistungshalbleitermodul (1) nach Anspruch 1,
wobei die Zentriereinrichtung (9) aus eine dauerelastischen Material ausgebildet ist und hierdurch eine kraftschlüssige Verbindung der Zentriereinrichtung (9) zum Sandwich (40) ausgebildet wird.

3. Leistungshalbleitermodul (1) nach Anspruch 1,
wobei der Querschnitt der Zentriereinrichtung (9) im Wesentlichen kreisförmig (90b) ausgestaltet ist.

4. Leistungshalbleitermodul (1) nach Anspruch 1,
wobei der Querschnitt der Zentriereinrichtung (9) im Wesentlichen meniskusförmig (90a) ausgestaltet ist, die Nut (96) in der konvexen Fläche angeordnet ist und die Enden des Meniskus die jeweils zugeordnete Dichteinrichtung (92) ausbilden.

5. Leistungshalbleitermodul (1) nach Anspruch 1,
wobei die Dichteinrichtungen (92) in Ausnehmungen (36) der zugeordneten Lastanschlusskörper (10; 20) angeordnet sind.

6. Leistungshalbleitermodul (1) nach Anspruch 1,
wobei die Dichteinrichtungen (92) plan an zugeordneten Lastanschlusskörpern (10; 20) anliegen.

7. Leistungshalbleitermodul (1) nach Anspruch 1,
wobei der Durchmesser der Metallzylinder (42; 46) und des Leistungshalbleiterbauelements (44) ein Verhältnis zur jeweiligen eigenen Höhe von mindestens 10:1 aufweist.

8. Leistungshalbleitermodul (1) nach Anspruch 1,
wobei ein Lastanschlusskörper (10; 20) eine Ausnehmung (30) mit einer ersten Dichtfläche (18) zur Aufnahme einer Kontakteinrichtung (70) aufweist und diese eine zweite zur ersten Dichtfläche (14) angeordnete Dichtfläche (72) aufweist und wobei zwischen den beiden Dichtflächen (18; 72) ein Dichtring (80) angeordnet ist.

9. Leistungshalbleitermodul (1) nach Anspruch 8,
wobei die Kontakteinrichtung (70) mittels einer Schnapp- Rast- Verbindung in dem Lastanschlusskörper (10; 20) angeordnet ist und somit der Dichtring (80) mit Druck beaufschlagt ist.
